# EUROPÄISCHE PATENTSCHRIFT

(11) **EP 1 556 901 B1**
(45) Veröffentlichungstag und Bekanntmachung des Hinweises auf die Patenterteilung: **28.05.2008**
(21) Anmeldenummer: 03775056.9
(22) Anmeldetag: 09.10.2003
(51) Int. Cl.: H01L 31/0256, H01L 31/18, H01L 31/032, H01L 31/0392

(54) **SCHICHTANORDUNG AUS HETEROVERBUNDENEN HALBLEITERSCHICHTEN MIT ZUMINDEST EINER ZWISCHENGELAGERTEN TRENNSCHICHT UND VERFAHREN ZU IHRER HERSTELLUNG**
LAYER ARRANGEMENT OF HETERO-CONNECTED SEMICONDUCTOR LAYERS, COMPRISING AT LEAST ONE INTERMEDIATE SEPARATION LAYER, AND METHOD FOR THE PRODUCTION THEREOF
ENSEMBLE DE COUCHES SEMI-CONDUCTRICES A LIAISON HETEROGENE COMPORTANT AU MOINS UNE COUCHE DE SEPARATION INTERMEDIAIRE ET PROCEDE DE REALISATION ASSOCIE

(30) Priorität: 09.10.2002 DE 10247735
(43) Veröffentlichungstag der Anmeldung: 27.07.2005
(73) Patentinhaber: Hahn-Meitner-Institut Berlin GmbH, 14109 Berlin (DE)
(72) Erfinder: FUERTES MARRON, David, 10557 Berlin (DE); MEEDER, Alexander, 10622 Berlin (DE); WÜRZ, Roland, 171394 Kernen (DE); SCHEDEL-NIEDRIG, Thomas, 14532 Kleinmachnow (DE); LUX-STEINER, Martha, Christina, 14263 Berlin (DE)
(74) Vertreter: Rudolph, Margit
(86) Internationale Anmeldenummer: PCT/DE2003/003371
(87) Internationale Veröffentlichungsnummer: WO 2004/034478

(56) Entgegenhaltungen:
- WO-A-01/04964
- US-A- 4 314 256
- NISHITANI M ET AL: "FABRICATION OF SUBSTRATE-TYPE CUINSE2 THIN FILM SOLAR CELLS" SOLAR ENERGY MATERIALS AND SOLAR CELLS, ELSEVIER SCIENCE PUBLISHERS, AMSTERDAM, NL, Bd. 35, Nr. 1/4, 1. September 1994 (1994-09-01), Seiten 203-208, XP000737070 ISSN: 0927-0248
- LUX-STEINER M C ET AL: "Processes for chalcopyrite-based solar cells" THIN SOLID FILMS, ELSEVIER-SEQUOIA S.A. LAUSANNE, CH, Bd. 361-362, Nr. 1, Februar 2000 (2000-02), Seiten 533-539, XP004187533 ISSN: 0040-6090

## Beschreibung

Die Erfindung bezieht sich auf eine Schichtanordnung aus heteroverbundenen Halbleiterschichten auf einem Substrat mit zumindest einer zwischengelagerten Trennschicht mit vorgegebener Schichtgitterstruktur zur definierten mechanischen Trennung der Halbleiterschichten unter Beteiligung eines Chalkogens in allen Schichten und auf ein Verfahren zur Herstellung einer derartigen Schichtanordnung.

Eine Schichtentrennung in halbleitenden Heteroverbindungsmaterialien wird zunehmend durchgeführt, um eine auf einem Ausgangssubstrat aufgewachsene Schichtanordnung nach ihrer Trennung von diesem Substrat weiterverarbeiten zu können. Dabei kann es sich beispielsweise um den Transfer auf ein flexibles Substrat und um weitere Beschichtungen handeln, um spezielle Dünnschicht-Solarzellen herzustellen. Ein Hauptanwendungsgebiet der Schichtentrennung liegt somit im Gebiet der Photovoltaik-Technologie. Aus der WO 01/04964 A1 ist eine flexible Dünnschicht-Solarzelle bekannt, bei der eine Opferschicht (dort NaCl) als Trennschicht auf das starre Glassubstrat zusätzlich aufgebracht wird. Die gesamte abzutrennende Solarzellenstruktur (hier Polyimid, metallische Molybdän-Rückkontaktschicht, Absorberschicht und Fensterschicht (dort Kadmiumsulfid-Zinkoxid CdS-Zn0)) wird anschließend auf die Trennschicht aufgebracht. Die heterogene Solarzellenstruktur wird dann durch nasschemisches Auflösen der Zwischenschicht in Wasser vom starren Substrat getrennt, was technologisch relativ problematisch ist und eine Reihe von Einschränkungen mit sich bringt.

Ohne einen chemischen Auflösungsprozess arbeiten mechanische Trennverfahren, die auf einer Auf- oder Abspaltung von Trenngräben oder speziell strukturierten Trennschicht beruhen. Aus der EP 0 334 111 A1 ist ein Verfahren zur integrierten Serienverschaltung von Dickschichtsolarzellen bekannt, bei dem Trenngräben zum Anbringen von leitenden Verbindungen zwischen den Zellen mittels einer Abhebetechnik ("lift-off-Technik") in der Dickschicht erzeugt werden. Dies geschieht dadurch, dass ein Streifenmuster als Paste im Siebdruckverfahren vor der ganzflächigen Abscheidung einer Dickschicht (dort polykristallines Silizium) auf das mit der strukturierten Grundelektrode versehene Substrat aufgebracht wird und auch vor dem Abscheiden der Deckelektrodenschicht wieder entfernt wird. Mit einem derartigen Verfahren können Trenngräben hergestellt werden, wie sie zur elektrischen Isolation von Solarzellen in einem verschalteten Solarmodul erforderlich sind. Dabei entstehen jedoch technologische Probleme beim Abheben der Trennpaste durch undefiniertes Reißen der Dickschicht. Eine großflächige Trennung von Schichten ist mit der Verwendung von Trennpaste, die in einem Siebdruckverfahren streifenförmig aufgebracht wird, nur schwer möglich.

Aus der US 4.445.965, von der die vorliegende Erfindung als nächstliegendem Stand der Technik ausgeht, ist ein Verfahren zur flächigen Schichtentrennung mittels mechanischen Spaltens bekannt, bei dem als Trennschicht Tellur mit einer planparallelen Schichtanordnung epitaktisch auf einem halbleitenden, einkristallinen Substrat (dort CdTe-Einkristall) in die zu trennende Schichtanordnung (dort Halbleiterschicht ebenfalls CdTe-Einkristall als Absorberschicht) eingebracht wird. Die Schichtanordnung wird dann zwischen zwei starre Trägerplatten, beispielsweise aus Glas, geklebt, die mittels eines Keils auseinander getrieben werden. Dadurch erfolgt eine Trennung im Bereich der Tellurschicht durch Bruch zwischen den parallel zum Substrat und zur Halbleiterschicht ausgerichteten Schichtgitterlagen ("peet-off-Technik"). Die Herstellung einer solchen Schichtenstruktur muss jedoch unter Ultrahochvakuum-Bedingungen stattfinden und ist somit unter anderem sehr kostenintensiv. Die Kontrolle zur Schichtherstellung ist relativ aufwändig, da spezielle Prozessparameter gefunden werden müssen, um ein epitaktisches Wachstum der Trennschicht auf dem einkristallinem Substrat sowie der abzutrennenden Dünnschicht zu realisieren. Für die Epitaxie werden üblicherweise sehr geringe Depositionsraten von 0,1 nm/min bis 1 nm/min verwendet, wodurch eine sehr lange Prozessdauer verursacht wird. Außerdem kann eine Rückstandsfreiheit an der Absorberschicht von der Trennschicht nicht garantiert werden. Für eine Weiterverarbeitung ist also zunächst zumindest eine Reinigung der frei gewordenen Oberfläche erforderlich.

Das Dokument US 4,314,256 beschreibt eine Schichtanordnung mit Metallschichten und Chalkogenidschichten.

**Aufgabe** für die vorliegende Erfindung ist es daher, eine Schichtanordnung der eingangs näher erläuterten Art dahingehend zu verbessern, dass eine rückstandsfreie und trockene Trennung von Halbleiterschichten in einer Heteroverbindung auf rein mechanischem Wege möglich ist. Weiterhin soll ein Verfahren zur Herstellung einer solchen Schichtanordnung mit einer speziellen Trennschicht angegeben werden, das einfach, schnell und kosten-günstig durchführbar ist. Die erfindungsgemäße **Lösung** für diese Aufgabe wird in dem Hauptanspruch bezüglich der verbesserten Schichtanordnung und in dem nebengeordneten Verfahrensanspruch bezüglich eines besonders geeigneten, weitergebildeten Verfahrens zur Herstellung der erfindungsgemäßen Schichtanordnungen angegeben. Vorteilhafte Ausführungsformen und Weiterbildungen der Erfindung sind den jeweiligen Unteransprüchen zu entnehmen.

Die Trennschicht bei der Erfindung weist eine in ihrer Geometrie definiert präparierte, vasenförmige Struktur im Submikrometerbereich auf, durch die ein rückstandsfreies Abziehen der angrenzenden Halbleiterschicht ermöglicht wird. Dazu ist die Trennschicht als Metalldichalkogenidschicht ausgebildet, deren Schichtgitterstruktur aus einzelnen polykristallinen Schichtgitterlagen durch gezieltes "Verbiegen" an ihren beiden Schichtübergängen um 90° zueinander verdrehte Orientierungen aufweist. Dabei ist die Struktur der Trennschicht auf der Schichtseite zum Metallfilm bzw. zum Substrat hin senkrecht dazu orientiert. Innerhalb der einzelnen Schichtgitterlagen bestehen große Bindungskräfte zwischen den einzelnen Atomen, sodass eine Trennung durch ein Schichtgitterlage nur unter großem Krafteinsatz und nicht definiert möglich ist. Auf der anderen Schichtseite der Trennschicht zur Halbleiterschicht hin ist die Schichtgitterstruktur hingegen parallel dazu orientiert. Die geometrisch definierte Struktur kann zutreffend als "Vasenstruktur" bezeichnet werden. Die senkrecht orientierte Schichtgitterstruktur teilt sich an vielen Stellen auf und geht mit relativ geringen Biegeradien in beiden Richtungen in die parallel orientierte Schichtgitterstruktur über, sodass sich strukturell eine Vielzahl von nebeneinander liegenden "Vasen" in der Trennschicht ergibt. Dabei erstreckt sich die senkrechte Orientierung der Schichtgitterstruktur der Trennschicht bis fast an die Halbleiterschicht, sodass der Übergang in die parallel orientierte Schichtgitterstruktur erst direkt davor, also im obersten Bereich der Trennschicht nach ca. 95% bis 97% der Gesamtschichtstärke auftritt. Durch das Verbiegen der oberflächennah parallel verlaufenden Schichtgitterlagen der Trennschicht zu einem im Volumen der Trennschicht senkrechten Verlauf der einzelnen Schichtgitterlagen kommen auch im an die Halbleiterschicht angrenzenden Schichtbereich der Trennschicht die atomaren Bindungen zwischen den Atomen innerhalb der Schichtgitterlagen zum Tragen. Die obersten Schichten sind somit fest mit dem Inneren der Trennschicht verbunden. Außerdem liegt eine feste Verbindung zum Metallfilm vor. Die Abtrennung einer angrenzenden Schicht auf der parallel orientierten Schichtseite kann hingegen ohne größeren Kraftaufwand rein mechanisch und unter trockenen Verhältnissen ohne Vornahme chemischer Reaktionen erfolgen. Eine auf die Trennschicht aufgebrachte Halbleiterschicht kann im Sinne einer "peel-off-Technik" im Nachweisbereich rückstandsfrei von der Trennschicht abgezogen werden. Somit wirkt die Trennschicht auf dieser Schichtseite wie eine schmierende Graphitschicht, während sie auf der anderen Schichtseite mit dem Metallfilm fest verbunden ist. Deshalb bleibt die Trennschicht beim Abziehvorgang vollständig auf dem Metallfilm erhalten und zerreißt nicht in einzelne Anteile, die unvorhersehbar verteilt an den benachbarten Schichten zurückbleiben.

Metalldichalkogenidschichten (MeX₂) sind aus der Literatur allgemein bekannt, wobei für das Metall bevorzugt Molybdän Mo oder Wolfram W und für das Chalkogen bevorzugt Schwefel S oder Selen Se verwendet wird (vgl. **Veröffentlichung I** von N. Barreau et al. «MoS2 textured films grown on glass substrate through sodium sulfide based compounds» J. Phys. D : App. Phys. 35 (2002) pp 1197-1203). Bekannte Metalldichalkogenidschichten zeigen zwei, bislang grundsätzlich alternativ auftretende, unterschiedliche Lagenstrukturen, die als Typ (I) mit den X-Me-X-Lagen senkrecht zur Substratebene (c-Achse damit parallel zur Substratebene) bzw. als Typ (II) mit den X-Me-X-Lagen parallel zur Substratebene (c-Achse damit senkrecht zur Substratebene) bekannt sind (vgl. **Veröffentlichung II** von S. Nishiwaki et al. «MoSe2 layer formation at Cu(In, Ga)Se2/Mo Interfaces in High Efficiency Cu(In1-xGax)Se2 Solar Cells» Jap. J. Appl. Phys. 37 (1998) L71 und **Veröffentlichung III** von A. Jäger-Waldau et al. «Composition and Morphology of MoSe2 Thin Films» Thin Solid Films 189 (1990) pp 339-345). Der bei der vorliegenden Erfindung durch eine gezielte Präparation in der Metalldichalkogenidschicht erzeugbare Wechsel in der Orientierung von senkrechtem Lagenwachstum hin zu einem parallelen Lagenwachstum innerhalb ein und derselben Schicht, der zu der Vasenstruktur in der Trennschicht führt, ist hingegen neu. Dies ist die nötige Anforderung an eine erfolgreiche Schichtentrennung der Halbleiterschicht von der Trennschicht und zwar exakt an der dazwischen liegenden Grenzfläche.

In der **Veröffentlichung IV** von J. Moser et al. «Growth mechanism and nearinterface structure in relation to orientation of MoS2 sputtered film» (J. Mater. Res. 7(3) (1992) pp 734-740) wird die Ablagerung von MoS₂ auf einem Siliziumsubstrat durch rf-Magnetron-Sputtern beschrieben. Hier wird eine Struktur aus Schichtgitterlagen, die zunächst parallel zum Substrat und dann senkrecht dazu orientiert sind, aufgezeigt. Diese als "Branchingstruktur" bezeichnete natürlich gewachsene Struktur tritt direkt sofort nach dem Aufwachsen von nur wenigen parallelen Schichtgitteriagen in der Schicht in Rückkopplung auf die Substratoberfläche auf. Sie ist zufälliger Natur und resultiert aus komplexen dendritischen Strukturen im Substratverbund. Eine gezielte Beeinflussung der Branchbildung ist - auch unter Anwesenheit weiterer chemischer Spezies - nicht möglich. Einen Einfluss hat jedoch der Wasserdampfgehalt bei der Deposition, wobei ein weiterführender Einfluss von Wassermolekülen nicht festgestellt werden konnte. Computersimulationen der Branchbildung haben gezeigt, dass diese als ein Ergebnis von kongruenten Gitterdispositionen kristalliner Bereiche beider Orientierungstypen anzusehen sind. Theoretische Grundlagen für die Branchbildung existieren nicht. Die Vasenstruktur in der Trennschicht bei der Schichtanordnung nach der Erfindung hingegen tritt nicht durch eine willkürliche Branchbildung, sondern durch eine gezielte Beeinflussung der Schichtmorphologie bei der Deposition der Trennschicht auf. Außerdem handelt es sich nicht um eine orthogonale Seitenarmbildung, sondern um eine kontinuierliche Überführung zwischen den beiden Orientierungstypen im Sinne einer Schichtenverbiegung. Desweiteren verläuft die Ausrichtung der Vasenstruktur bei der beanspruchten Trennschicht entgegen der bekannten Branchingstruktur. Beansprucht wird zunächst eine senkrechte Orientierung, die dann in eine parallele Orientierung zur Halbleiterschicht übergeht. Nur durch diese Orientierungsausrichtung ist ein rückstandfreies Abziehen der Halbleiterschicht von der Trennschicht möglich. Mit dem natürlichen Branchingprozess ist diese spezielle Strukturierung nicht zu erreichen. Durch die Anwesenheit von weiteren chemischen Spezies wird bei der Herstellung der Schichtanordnung nach der Erfindung vielmehr der Branchingprozess bewusst vermieden.

In der **Veröffentlichung V** von T. Wada «Microstructural characterization of high-efficiency Cu(In, Ga)Se2 solar cells» (Sol. Energy Mat. Sol. Cells 49 (1997) pp 249-260) werden - wie in der Veröffentlichung II - die verschiedenen Einzelformationen von MoSe₂ in einer seleniumangereicherten Atmosphäre auf einem Molybdänsubstrat bei einer physikalischen Dampfabscheidung (PVD) beschrieben. In dieser Veröffentlichung wird weiterhin explizit darauf hingewiesen, dass die Molybdänselenidschicht zwischen den einzelnen Gitterschichten einfach zu trennen ist. Deshalb soll beim Schichtenwachstum gezielt auf eine senkrechte Orientierung geachtet werden, um eine mögliche Schichtentrennung als ungewollten Effekt zu vermeiden. Hinweise für eine definierte Präparation einer kombinierten Vasenstruktur aus beiden Orientierungstypen zur Erzeugung einer Trennschicht gemäß der Erfindung sind der Veröffentlichung V jedoch nicht zu entnehmen. Bei der Erfindung wird die Möglichkeit der Schichtentrennung zwischen respektive von den parallelen Schichten bei einer geeigneten Aufteilung zwischen dem Anteil der senkrecht und der parallel orientierten Gitterschichtlagen gezielt so ausgenutzt, dass einerseits ein unbeabsichtigtes Ablösen vermieden und andererseits ein bewusstes Abziehen der Trennschicht durch geringe Kraftaufbringung ermöglicht wird. Desweiteren wird in der Veröffentlichung V das PVD-Verfahren verwendet, das sich in den Wachstumsbedingungen und Prozessparametern wesentlich von dem CVD-Verfahren unterscheidet, das zur Herstellung der beanspruchten Schichtanordnung bevorzugt eingesetzt wird. Weitere Parameter mit einem Einfluss auf das Wachstum von strukturierten MoS₂-Schichten mit senkrechter oder paralleler Orientierung sind der **Veröffentlichung VI** (Molybdän, Tantal oder Wolfram als Substrat, Nickelüberzug als Metallfilm) von E. Gourmelon et al. «Crystalline properties of MoS2 thin films grown on metallic substrates» (Mat. Chem. Phys. 58 (1999) pp 280-284) und der bereits genannten Veröffentlichung I (Natrium, Nickel, Kalium und Natriumfluorid als Additive mit einem Einfluss auf die Kristallisation und den Strukturbildungsprozess) zu entnehmen. In der Veröffentlichung I sind außerdem experimentelle Resultate offenbart, die sich auf eine Bildung von (MoS₄)²⁻ -Komplexen während der Sulfurisierung der Molybdänschichten beziehen, die Kupfer, Gallium und/oder Natrium binden können. Diese metastabilen Tetraschwefelmolybdat-Verbindungen sind vom stöchiometrischen Typ A₂MoS₄ (A⁺= Kation), der in der orthorhombischen β-Struktur von K₂SO₄ kristallisiert und unterhalb einer Prozesstemperatur von 450°C wieder zerfällt und zwar in Molybdändisulfid und Schwefel. Es wird weiterhin aufgezeigt, dass das Chalkogenidwachstum Typ II mit einer parallelen Orientierung zum Substrat durch das Wachstum des Tetraschwefelmolybdats beeinflusst wird. Ein Hinweis auf eine gezielte Kombination der beiden Orientierungstypen ist jedoch keiner der genannten Veröffentlichungen zu entnehmen.

Metalldichalkogenid (X-Me-X)-Schichten lassen sich durch unterschiedliche, an sich bekannte Prozesse herstellen. Grundsätzlich ist das reaktive Wachstum der Metalldichalkogenidschicht vom lonen- und Elektronentransport durch die bereits gewachsene Schicht abhängig. Die lokale treibende Kraft für diesen Transport und damit auch für die Wachstumsrate ist durch die Differenz der chemischen Potenziale an den beiden Grenzflächen der Schicht festgelegt und somit umgekehrt proportional zur Schichtdicke. Das Produkt der Transportparameter wie die Diffusionsraten der Metallionen und der Elektronen (Dᵢₒₙ, Dₑₗₑₖₜᵣₒₙ) legen den Fluss von Ionen durch die bereits gebildete Metalldichalkogenid -Produktschicht fest und damit die Reaktionsrate zwischen den MetallIonen mit dem Chalkogenwasserstoff an der Grenzschicht. Sowohl die Morphologie als auch die elektronischen Eigenschaften der Metalldichalkogenidschicht, die sich bei der Erfindung während des Wachstums der Halbleiterschicht als insbesondere photoaktive Absorberschicht ausbildet, resultieren nicht aus einer einfachen Reaktion des Metallfilms mit dem Chalkogenwasserstoff. Die Schichtstruktureigenschaften hängen u.a. von den Metall-Depositionsbedingungen, den Metalldichalkogenid-Wachstumsbedingungen sowie der Anwesenheit von bestimmten Elementen bzw. Verbindungen ab, die katalytisch aktiv sind, wie Kupfer, Gallium, Indium, Nickel und Alkalimetalle.

Das gesamte Wachstum der Schichtanordnung nach der Erfindung kann vorteilhaft mit dem Verfahren der chemischen Gasphasenabscheidung erfolgen, wie es in der DE 198 55 021 C1 offenbart wird. Mit Hilfe der hierin beschriebenen chemischen Verdampfungsdeposition (chemical vapour deposition - CVD) können polykristalline Chalkopyritschichten auf unterschiedlichen Substraten hergestellt werden. Das sehr kostengünstige Abscheideverfahren in einem offenen System basiert dabei auf einer Kombination der bekannten Methoden VPE (vapour phase epitaxy) im offenen System und der CVT (chemical vapour transport) im geschlossenen System. Zunächst findet eine Verflüchtigung der beispielsweise binären Quellenmaterialien durch Reaktion mit Halogenen zu gasförmigen Halogeniden und dann deren Reaktion zu einer festen, beispielsweise ternären Halbleiterverbindung statt. Bei diesem Abscheideverfahren wird die Trennschicht mit Vasenstruktur gemäß der Erfindung direkt in-situ während des Depositionsprozesses der Halbleiterschicht hergestellt, wodurch sich das Verfahren zu einem einstufigen Prozess wesentlich vereinfacht. Der Prozess unter reaktiven CVD-Bedingungen liefert dabei eine Schichtenstruktur bestehend aus polykristallinen Schichten, deren Deposition vereinfacht und schneller abläuft. Weiterhin erfolgt eine Weiterbearbeitung der beanspruchten Schichtanordnung, beispielsweise zu einer vollständigen Solarzellenstruktur, erst nach dem mechanischen Trennen. Dadurch können vorteilhaft sehr unterschiedliche Heterostrukturen - nicht nur Solarzellstrukturen - in unabhängigen Prozessen erzeugt werden. Weiterhin umfasst das beanspruchte Herstellungsverfahren ein rein mechanisches, trockenes Abziehen der gebildeten Halbleiterschicht ohne einen nasschemischen Auflösungsprozess. Von den bekannten lift-off-Verfahren, bei denen jeweils eine Paste im Siebdruckverfahren aufgebracht wird, die dann an bestimmten Stellen (Streifenmuster) zur Herstellung von Trenngräben abgehoben wird, unterscheidet sich das beanspruchte Verfahren als sogenanntes "peel-off-Verfahren" ebenfalls signifikant.

Bei dem bei der Herstellung einer Anordnung aus heteroverbundenen Halbleiterschichten (am Beispiel von ternärem Kupfer-Gallium-Diselenid CGSe) und der Trennschicht mit Vasenstruktur nach der Erfindung erfolgenden Metalldichalkogenid-Wachstum können in einem Prozessschritt zwei unterschiedliche Wachstumsschritte beschrieben werden (am Beispiel einer Molybdändiselenidschicht als Trennschicht) :
1. In einer ersten, zeitlich kurzen Wachstumsphase entstehen MoSe₂-Lagen vom Typ (I), d.h. mit einzelnen Gitterstrukturlagen, die hauptsächlich senkrecht zur Metallfilmebene hin orientiert sind. Dieser erste Reaktionsschritt ist eine kontrollierte Reaktion zwischen Selenwasserstoff als Reaktionsgas und dem Molybdän-Metallfilm. Diese erste Wachstumsphase liefert etwa 95% bis 97% der gesamten Metalldichalkogenid-Trennschicht.
Die erforderlichen Standard-CVD-Prozessparameter für das Lagenwachstum vom Typ (I) beim chemischen Abtrag von Ga₂Se₃- und Cu₂Se-Quellenmaterialien in Einzelkomponenten sind im Folgenden angegeben :

| | | | | | |
|---|---|---|---|---|---|
| T_{jod} | = 50°C | Qₗ₂ | = 1,23 ml/min | P_{jodquelle} | = 60 kPa |
| T_{quelle} | = 600°C | Q_{HCl} | = 150 ml/min | P_{Prozess} | = 10 kPa |
| T_{substrat} | = 500°C | Q₁ | =260 ml/min | | |
| | | Q₂ | = 200 ml/min | | |
| | | Q₃ | = 310 ml/min | | |

Aufgrund der chemischen Verflüchtigung der beiden Quellenmaterialien Ga₂Se₃ bzw. Cu₂Se unter den gasförmigen HCI- bzw. H₂/l₂-Standard-Bedingungen bei einer Quellentemperatur T_{Q} = 600°C und einem Verhältnis von verflüchtigtem, gasförmigen GaCl bzw. Cul in der Gasphase von 5 : 1 (oder größer) findet dieser erste MoSe₂-Wachstumsschritt typischerweise bei einer Substrattemperatur T_{substrat} = 500°C auf der Substratseite bei einem Überschuss von H₂Se in der Gasphase statt (g= gasförmig, s= fest):
- **Verflüchtigung von Quellenmaterial 1:**
   5 x [Ga₂Se₃ (s) + 2 HCl (g) + 2 H₂ (g) ↔ 2 GaCl (g) + 3 H₂Se (g)] → 5-fache Konzentration in der Gasphase bei MoSe₂-Abscheidung
- **Verflüchtigung von Quellenmaterial 2:**
   1 x [Cu₂Se (s) + I₂ (g) + H₂ (g) ↔ 2 Cul(g) + H₂Se (g)] → 1-fache Konzentration in der Gasphase bei MoSe₂-Abscheidung
- **Reaktion zum MoSe₂-Wachstum :**

   2 H₂Se (g) + Mo (s) ↔ MoSe₂ (s) + 2H₂ (g)
Da die treibende Kraft für den Mo-Ionentransport durch die bereits gebildete MoSe₂-Produktschicht und damit auch für die Wachstumsrate der Produktschicht umgekehrt proportional zur Schichtdicke ist, findet mit zunehmender Schichtdicke eine Abnahme der MoSe₂-Wachstumsrate statt. Damit verlangsamt sich das Wachstum der MoSe₂-Schicht mit Orientierung der MoSe₂-Lagen vom Typ (I) -senkrecht- und das langsamere Wachstum der MoSe₂-Lagen vom Typ (II) -parallel- setzt nunmehr ein.
2. Die sich an die erste, kurze Wachstumsphase anschließende (oder auch simultan zu dieser ablaufende) zweite, langsamere Wachstumsphase an der Gas/MoSe₂-Grenzschicht resultiert in einer Änderung der Orientierung der MoSe₂-Lagen von senkrecht hin zu parallel (Typ (II)). Die sich ergebende komplette Schichtstruktur vom Typ I und Typ II lässt sich sehr gut als Vasenstruktur beschreiben. Analog zu den bereits erwähnten experimentellen Ergebnissen (vergleiche Veröffentlichung I) kann von der Bildung anionischer Tetrathiomolybdat-(MeCh₄)²⁻-Gruppen während der Reaktion ausgegangen werden, die mit den entsprechenden Kationen (Cu⁺/Cu²⁺, Ga⁺/Ga³⁺, Ni²⁺, Na⁺) metastabile Komplexe vom Typ A₂MoCh₄ (A⁺ = Kation) bilden. Dabei lässt sich mittels des Chlorflusses im Reaktionsgas der Gallium-Chlorid-Gehalt über dem Substrat einstellen. Das dort deponierte Gallium wirkt dann als eine Art Katalysator und formt den metastabilen Komplex des genannten Typs :
- **Reaktion zum metastabilen Komplex-Wachstum :**

   2GaCl (g) + 4H₂Se (g) + Mo (s) ↔ Ga₂MoSe₄ (s) + 2HCL (g) + 3H₂ (g)
Das Lagenwachstum vom Typ (II) wird direkt mit der Bildung solcher Tetrathiomolybdate als Zwischenspezies in Verbindung gebracht, dessen charakteristische β-K₂SO₄ (orthorhombisch) Struktur eine Chalkogendiffusion nach der thermischen Zersetzung des Komplexes mit der Orientierung der verbleibenden MoCh₂-Lagen parallel zur Substratebene hin favorisiert. Allgemein gilt mit Me = Metall, X = Chalkogen und A = Kation:

*A₂MeX₄* → *MeX₃* + A₂X

*MeX₃* → *MeX₂* + X

Zusammenfassend gesehen lassen sich also bei der beanspruchten Schichtanordnung nach der Erfindung die Trennschicht mit Vasenstruktur und die Halbleiterschicht in einem gemeinsamen Prozessschritt herstellen, wenn ein Element aus der Halbleiterschicht als Katalysator zur Komplexbildung geeignet ist. Als Beispiel sei das Wachstum einer CuGaSe₂-Absorberschicht auf einer Molybdänschicht mittels der oben beschriebenen Methode genannt. Gallium wirkt hierbei als Katalysator zur parallelen Ausrichtung der MoSe₂-Trennschicht an der Grenze zur CuGaSe₂-Absorberschicht. Beide Schichten wachsen gleichzeitig übereinander auf, wobei das Wachstum der MoSe₂-Trennschicht in zwei Wachstumsschritten mit erfindungsgemäß unterschiedlicher Orientierung erfolgt.

Anwendung findet die Schichtanordnung nach der Erfindung aus heteroverbundenen Halbleiterschichten mit einer zwischengelagerten Trennschicht auf unterschiedlichen technologischen Gebieten. Es sei an dieser Stelle erwähnt, dass je nach Anwendungsfall eine zyklische Verfahrenswiederholung von Vorteil sein kann. Dabei kann eine Variation der eingesetzten Materialien erfolgen, muss aber nicht. Es entsteht so eine multiple Schichtanordnung mit mehreren Trennschichten mit Vasenstruktur, die alle entsprechend nacheinander mechanisch abgezogen werden können. Ein derartiges Vorgehen führt somit zu einer rationalisierten Fertigung. Als Anwendungsbeispiele seien hier genannt:

### • Beispiel zur Herstellung einer flexiblen neuen Solarzellstruktur:

1. Herstellung der Heterostruktur Glas/Mo-Schicht/MoSe₂-Schicht/ CuGaSe₂-Schicht in zwei Schritten: i) Mo-Aufsputtern auf Glassubstrat und ii) CVD-Prozess für die MoSe₂/CuGaSe₂-Schichtstruktur
2. Aufbringen einer elektrisch-leitenden und flexiblen Cu-Folie als Rückkontakt mittels eines elektrisch leitenden Zwei-Komponenten-Klebers auf die Oberfläche der CuGaSe₂-Schicht.
3. Nach einem Heizschritt (bei ca. 100°C sowie anschließendem Abkühlvorgang) wird die Glas/Mo/MoSe₂-Schichtstruktur von der neuen p-leitenden CuGaSe₂/Kleber/Cu-Folien-Schichtstruktur mechanisch getrennt. Diese neue Schichtstruktur kann nun unabhängig prozessiert werden, wie das konkrete Beispiel zeigt: i) Aufbringen einer CdS-Pufferschicht (chemische Badabscheidung), ii) Aufsputtern einer n-leitenden ZnO-Fensterschicht, sowie zum Schluss iii) Aufdampfen der metallischen Frontkontakte.

### • Beispiel zur Herstellung einer neuartigen Grundstrukturierung zur Anwendung in der Halbleitertechnologie

Auf ein Substrat (beispielsweise Na-haltiges Glas) wird eine strukturierte Maske aufgelegt. Anschließend findet die Aufbringung einer Molybdänschicht statt (typischerweise einige µm dick). Nach dem Entfernen der Maske bleibt die gewünschte Struktur des Metallfilms auf dem Substrat. Das Deponieren einer Halbleiterschicht in Chalkogenwasserstoff (H₂Ch: H₂S, H₂Se, H₂Te) führt zur Ausbildung der MoCh₂-Zwischenschicht mit definierter geometrischer Lagenstruktur und zeigt zudem die vorher aufgeprägte Maskenstrukturierung. Die deponierte Halbleiterschicht kann nun durch mechanisches Trennen von der strukturierten Zwischenschicht abgelöst werden und zeigt somit eine Strukturierung, die anschließend beispielsweise für das Einbringen von metallischen Leiterbahnen in die Gräben der Struktur weiter verwendet werden kann.

Zur weiteren Verdeutlichung der Erfindung werden **Ausbildungsformen der Erfindung** nachfolgend anhand der schematischen Figuren noch näher erläutert. Dabei zeigt :
- **Figur 1**: eine prinzipielle Schichtanordnung nach der Erfindung,
- **Figur 2**: eine TEM-Aufnahme in die Mikrostruktur der Schichtanordnung gemäß Figur 1,
- **Figur 3**: eine TEM-Aufnahme der Trennschicht mit Vasenstruktur und
- **Figur 4**: eine Tabelle aus Untersuchungsergebnissen nach der Trennung.

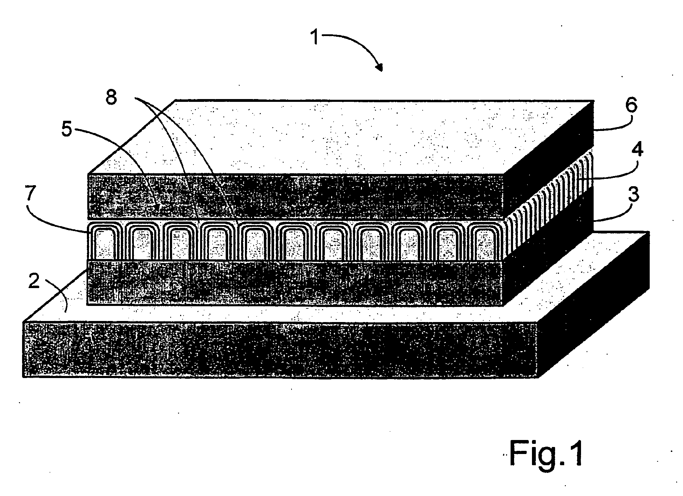

Die **Figur 1** zeigt ein schematisches Übersichtsbild einer Schichtanordnung **1** nach der Erfindung. Auf ein starres Substrat **2** aus Glas ist ein Metallfilm **3** als dünner Film beispielsweise durch Sputtern aufgebracht. Dabei kann das Glas Natrium enthalten, das als mögliche Einflusskomponenten bei der Strukturbildung auftritt. Der Metallfilm **3** kann beispielsweise aus dem Metall Molybdän Mo bestehen und als Metall-Rückkontakt ausgebildet sein. Oberhalb des Metallfilms **3** befindet sich eine zwischengelagerte Trennschicht **4** mit einer Vasenstruktur **5** zur definierten mechanischen Trennung einer nachfolgenden Halbleiterschicht **6,** die im Ausführungsbeispiel als ternäres Kupfer-Gallium-Diselenidschicht (CuGaSe₂ oder abgekürzt CGSe mit Selen als Chalkogen) ausgebildet ist.

Die Trennschicht 4 besteht im gewählten Ausführungsbeispiel aus Molybdändiselenid MoSe2 und weist einzelne Schichtgitterlagen **7** auf, innerhalb derer die Bindung der einzelnen Atome sehr stark ist (van der Waals Bindung). Zwischen den Schichtgitterlagen **7** besteht hingegen nur eine schwache Bindungskraft. Ein Auftrennen der Trennschicht **4** zwischen respektive von den Schichtgitterlagen **7** auf mechanischem Wege ist somit möglich (bislang wird im Stand der Technik - wie weiter oben näher ausgeführt - nur die Vermeidung einer Auftrennung diskutiert). Die Vasenstruktur **5** besteht zum größten Anteil (Bereich von 95% bis 97% der Gesamtschichtstärke) aus einem Typ 1 mit einer senkrechten Ausrichtung der Schichtgitterlagen **7** zum Metallfilm **3** bzw. zum Substrat **2.** Durch die senkrechte Orientierung mit dem großen Zusammenhalt der Atome in den einzelnen Schichtgitterlagen **7** besteht auch eine mechanisch stabile Anheftung dieses Strukturbereichs an den Metallfilm **3.** Die Trennschicht **4** weist eine Vasenstruktur **5** mit vasenförmigen Ausbildungen auf. Dabei teilen sich direkt an der Grenzfläche zur Halbleiterschicht **6** die zuvor senkrecht verlaufenden Schichtgitterlagen **7** an vielen Gabelungsstellen **8** auf und gehen kontinuierlich mit einem gekrümmten Verlauf in eine Orientierung vom **Typ II** mit einer parallelen Ausrichtung der Schichtgitterlagen **7** zur Halbleiterschicht **6** über. Da der Zusammenhalt zwischen respektive an den parallelen Schichtgitterlagen **7** relativ schwach ist, kann nunmehr die Halbleiterschicht **6** von der Trennschicht **4** durch Abziehen einfach und auf trockenem Wege abgetrennt werden. Dabei erfolgt eine saubere Trennung ohne messbare Rückstände der Trennschicht **4** an der Halbleiterschicht **6.** Die abgezogene Halbleiterschicht **6** kann dann weiterverarbeitet werden, beispielsweise mit weiteren Schichten belegt und/oder auf ein flexibles Substrat aufgebracht werden. Der gesamte Herstellungs- und Trennvorgang kann einmalig oder auch zyklisch mit oder ohne Materialvariation in den einzelnen Schichten durchgeführt werden. Anwendungen finden sich entsprechend beispielsweise in flexiblen Dünnschicht- oder Tandemsolarzellen.

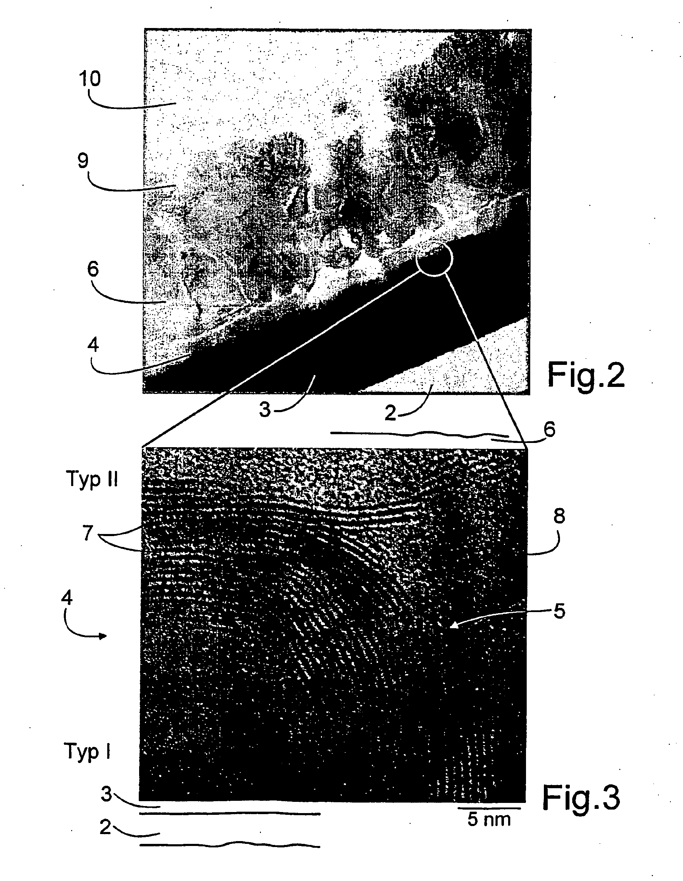

Die **Figur 2** zeigt eine hochaufgelöste Aufnahme mit einem Transmissionselektronenmikroskop (TEM) als Zoom in den Schichtaufbau **1** gemäß Figur 1 (Ausschnittsgröße 3 µm x 3 µm). Deutlich zu erkennen sind das Substrat **2,** der Metallfilm **3,** die Trennschicht **4** und die Halbleiterschicht **6.** Als Abschluss ist hier noch eine transparente Fensterschicht **9** mit einem aufgetragenen Kleber **10** dargestellt. Eine weitere TEM-Aufnahme als sehr starken Zoom in den Bereich der Trennschicht **4** gemäß Figur 3 (Ausschnittsgröße 30 nm x 30 nm) zeigt ausschnittsweise den Verlauf der Vasenstruktur **5** als Detail. Deutlich sind hier die einzelnen Schichtgitterlagen **7** zu erkennen, die zunächst senkrecht **(Typ I)** und dann parallel verlaufen **(Typ II).** Zwischen der Halbleiterschicht **6** und dem Bereich der parallel verlaufenden Schichtgitterstrukturen **(Typ II)** ergibt sich daraus eine Linie, die ebenfalls zu erkennen ist.

Eine der TEM-Aufnahme gemäß Figur 2 ähnliche TEM-Aufnahme ist auch aus folgender Internetseite des Anmelders bekannt **(Veröffentlichung VH** ,Stand 16.09.2002) :
http://www.hmi.de/bereiche/SE/SE2/arbeitsg/halbleiter/cvd/index.html.print
Eine Interpretation der dort sichtbaren Linie als potenzielle Trennlinie im Sinne der Erfindung wird jedoch auf dieser Seite nicht gegeben. Diese konnte auch nicht erfolgen, da zum Veröffentlichungszeitpunkt noch keine Erkenntnisse über den vollständigen Strukturcharakter der erzeugten Metalldichalkogenidschicht und den daraus ableitbaren möglichen Anwendungen vorlagen. Dasselbe gilt für eine TEM-Aufnahme in der **Veröffentlichung VIII** der Erfinder im Jahresbericht 2001 des Anmelders (Th. Schedel-Niedrig et al. "CuGaSe2 by Chemical Vapor Deposition (CVD)", HMI Annual Report 2001 - Selected Results, pp 107-108, Fig. 3, veröffentlicht Juni 2002, abrufbar unter http://www.hmi.de/pr/druckschriften.html). Diese bekannte TEM-Aufnahme zeigt die Nanometerstruktur einer Molybdändiselenidschicht aus der Mitte der Schicht. In diesem Bereich sind die parallelen Schichtgitterlagen quasisenkrecht bzw. geneigt orientiert. Ein Hinweis auf eine durch eine spezielle Präparation hervorgerufene Vasenstruktur mit definiert senkrechten und parallelen Bereichen, wie sie für die Trennschicht in der Schichtanordnung gemäß der Erfindung beansprucht wird, ist auch dieser Veröffentlichung nicht zu entnehmen, da zum Zeitpunkt der Veröffentlichung noch keine Erkenntnisse über eine mögliche Verwendung einer Molybdändiselenidschicht als mechanische Trennschicht in einer Schichtanordnung vorgelegen haben.

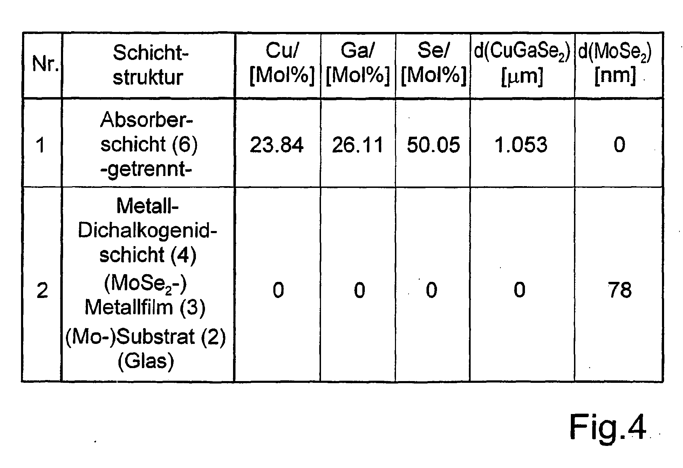

Die **Figur 4** zeigt eine Tabelle mit Ergebnissen der chemischen Zusammensetzung der einzelnen Schichten mittels der Röntgenfluoreszenzanalyse (RFA) nach dem mechanischen Abziehen der Halbleiterschicht **6** (Absorberschicht) von der Trennschicht **4.** Es zeigt sich, dass sich die Halbleiterschicht **6** direkt an der Grenzschicht zur Trennschicht **4** mechanisch von dem Metallfilm **3** (hier Mo) und damit vom Substrat **2** (hier Glas) trennen lässt. An der abgelösten Halbleiterschicht **6** (hier CuGaSe₂, Nr. 1) konnte kein Element von der Trennschicht **4** (hier MoSe₂, Nr. 2) innerhalb der Nachweisgrenzen von ca. 0,1 Atomprozent gemessen werden. Somit ist an der abgelösten Halbleiterschicht **6** kein MoSe₂ haften geblieben. Die Trennschicht **4** verblieb vollständig auf dem Metallfilm **3.**

### Bezugszeichenliste

- **1**: Schichtanordnung
- **2**: Substrat
- **3**: Metallfilm
- **4**: Trennschicht
- **5**: Vasenstruktur
- **6**: Halbleiterschicht
- **7**: Schichtgitterlage
- **8**: Gabelungsstelle
- **9**: Fensterschicht
- **10**: Kleber

- **Typ I**: senkrechte Schichtgitterorientierung
- **Typ II**: parallele Schichtgitterorientierung

## Patentansprüche

1. Schichtanordnung aus heteroverbundenen Halbleiterschichten auf einem Substrat mit zumindest einer zwischengelagerten Trennschicht mit vorgegebener Schichtgitterstruktur zur definierten mechanischen Trennung der Halbleiterschichten unter Beteiligung eines Chalkogens in allen Schichten,
**dadurch gekennzeichnet, dass**
das Substrat (2) mit einem Metallfilm (3) beschichtet ist und die Trennschicht (4) als Metalldichalkogenidschicht unter Beteiligung des Metalls aus dem Metallfilm (3) und des Chalkogens aus zumindest einer Halbleiterschicht (6) ausgebildet ist und eine kontinuierliche, gebogene Vasenstruktur (5) mit einer am Übergang zum Metallfilm (3) senkrecht dazu ausgebildeten Schichtgitterstruktur (Typ I) und einer am Übergang zur Halbleiterschicht (6) parallel dazu ausgebildeten Schichtgitterstruktur (Typ II) aufweist, wobei die mechanische Trennung rückstandsfrei zu der Halbleiterschicht (6) erfolgen kann.

2. Schichtanordnung nach Anspruch 1,
**dadurch gekennzeichnet, dass**
das Substrat (2) als starres Glassubstrat ausgebildet ist.

3. Schichtanordnung nach Anspruch 1 oder 2,
**dadurch gekennzeichnet, dass**
der Metallfilm (3) aus Molybdän (Mo), die Halbleiterschicht (6) aus ternärem Kupfer-Gallium-Diselenid (CuGaSe₂) und die Trennschicht (4) aus Molybdän-Diselenid (MoSe₂) besteht.

4. Schichtanordnung nach einem der Ansprüche 1 bis 3,
**dadurch gekennzeichnet, dass**
auf die Halbleiterschicht (6) in einer Ausbildung als Absorberschicht eine flexible Kupferfolie als Rückkontakt und auf deren nach dem rückstandsfreien Abziehen von der Trennschicht (4) entstandene freie Seite eine Pufferschicht, eine Fensterschicht und metallische Frontkontakte aufgebracht sind, wobei die Kontakte mittels Leitkleber befestigt sind.

5. Verfahren zur Herstellung einer Schichtanordnung (1) aus heteroverbundenen Halbleiterschichten auf einem Substrat (2) mit zumindest einer zwischengelagerten Trennschicht (4) mit vorgegebener Schichtgitterstruktur zur definierten mechanischen Trennung der Halbleiterschichten (6) unter Beteiligung eines Chalkogens in allen Schichten, insbesondere nach den Ansprüchen 1 bis 4, mit den essenziellen Verfahrensschritten :
• Beschichten eines Substrats (2) mit einem Metallfilm (3),
• Abscheiden in einem offenen System von zumindest einer Halbleiterschicht (6) durch chemische Gasphasenabscheidung von zwei oder mehreren verschiedenen Halbleitermaterialien auf dem Substrat (2), wobei zumindest eines der Halbleitermaterialien (6) aus der Gruppe der Chalkogene stammt und eines als Katalysator zur zweistufigen in-situ-Bildung einer Metalldichalkogenidschicht als mechanische Trennschicht (4) zwischen dem Metallfilm (3) und der Halbleiterschicht (6) unter Beteiligung des Metalls aus dem Metallfilm (3) und des Chalkogens aus der Halbleiterschicht (6) dient, unter Anwesenheit eines Transportgases und eines Reaktionsgases mit den zwei Wachstumsphasen:
• **Wachstumsphase I** bei einer Prozesstemperatur oberhalb 450°C: Ausbildung einer senkrecht zum Metallfilm orientierten Schichtgitterstruktur (Typ I) in der Trennschicht (4) am Übergang zum Metallfilm (3) bis zur gesättigten Ausbildung metastabiler Komplexe aus dem Metall und dem Chalkogen unter der Kontrolle des Reaktionsgases,
• **Wachstumsphase II** : Ausbildung einer parallel zur Halbleiterschicht orientierten Schichtgitterstruktur (Typ II) in der Trennschicht (4) am Übergang zur Halbleiterschicht (6) durch Zersetzung der metastabilen Komplexe unter dem Einfluss des als Katalysator dienenden Halbleitermaterials und in Abhängigkeit von der Diffusion des Metalls aus dem Metallfilm (3) in die Trennschicht (4),
• Abziehen der Halbleiterschicht (6) von dem Substrat (2) unter mechanischer Schichtentrennung direkt am Übergang zur Trennschicht (4), wobei an der Halbleiterschicht (6) keine Rückstände der Trennschicht (4) verbleiben,
• Weiterprozessierung und/oder Weiterverarbeitung der abgezogenen Halbleiterschicht (6).

6. Verfahren nach Anspruch 5 mit einer zyklischen Wiederholung des Verfahrensablauf unter Variation der eingesetzten Materialien.

7. Verfahren nach Anspruch 5 oder 6 mit einer Maskenstrukturierung der Trennschicht (4).

8. Verfahren nach einem der Ansprüche 5 bis 7 mit Beschichten des Substrats (2) mit einem Metallfilm (3) durch Aufsputtern bei einem Prozessdruck in einem Bereich von 0,3 kPa bis 1 kPa oder Bedampfen.

9. Verfahren nach einem der Ansprüche 5 bis 8 mit Molybdän zur Herstellung des Metallfilms (3), mit binärem Ga₂Se₃ und/oder Cu₂Se als Quellmaterialien zur Abscheidung der Halbleiterschicht (6), mit Kupfer (Cu), Gallium (Ga), Indium (In), Nickel (Ni) oder einem Alkalimetall als Katalysator, mit Wasserstoff (H₂) als Transportgas und Chlorwasserstoff (HCL) als Reaktionsgas.

10. Verfahren nach Anspruch 9 mit den Prozessparametern Prozesstemperatur als Substrattemperatur in einem Bereich von 480°C bis 530°C, Prozessdruck in einem Bereich von 5 kPa bis 50 kPa, Wasserstofffluss in einem Bereich von 1000 ml/min bis 2000 ml/min und Chlorwasserstofffluss in einem Bereich von 50 ml/min bis 500 ml/min

## Claims

1. Layer arrangement consisting of hetero-connected semiconductor layers on a substrate having at least one interposed separation layer with a predetermined layer-grid structure for the defined mechanical separation of the semiconductor layers with participation of a chalcogen in all layers, **characterised in that** the substrate (2) is coated with a metal film (3) and the separation layer (4) is formed as a metal dichalcogenide layer with participation of the metal from the metal film (3) and the chalcogen from at least one semiconductor layer (6) and has a continuous, bent vase structure (5) with a layer-grid structure (type I) formed at the transition to the metal film (3) perpendicularly thereto and a layer-grid structure (type II) formed at the transition to the semiconductor layer (6) parallel thereto, in which case the mechanical separation can be effected in a residue-free manner with respect to the semiconductor layer (6).

2. Layer arrangement according to claim 1, **characterised in that** the substrate (2) is formed as a rigid glass substrate.

3. Layer arrangement according to claim 1 or 2, **characterised in that** the metal film (3) consists of molybdenum (Mo), the semiconductor layer (6) consists of ternary copper gallium diselenide (CuGaSe₂), and the separation layer (4) consists of molybdenum diselenide (MoSe₂).

4. Layer arrangement according to one of claims 1 to 3, **characterised in that** applied to the semiconductor layer (6) in a formation as an absorber layer there is a flexible copper foil as a rear contact and applied to the free side thereof that develops after the residue-free pull-off from the separation layer (4) there are a buffer layer, a window layer and metallic front contacts, with the contacts being secured by means of conductive adhesive.

5. Method for producing a layer arrangement (1) of hetero-connected semiconductor layers on a substrate (2) having at least one interposed separation layer (4) with a predetermined layer-grid structure for the defined mechanical separation of the semiconductor layers (6) with participation of a chalcogen in all layers, in particular according to claims 1 to 4, having the essential method steps:
• coating of a substrate (2) with a metal film (3),
• deposition in an open system of at least one semiconductor layer (6) by chemical vapour deposition of two or more different semiconductor materials on the substrate (2), with at least one of the semiconductor materials (6) coming from the group of chalcogens and one being used as a catalyst for two-stage in-situ formation of a metal dichalcogenide layer as a mechanical separation layer (4) between the metal film (3) and the semiconductor layer (6) with participation of the metal from the metal film (3) and the chalcogen from the semiconductor layer (6), in the presence of a transport gas and a reaction gas with the two growth phases:
• **growth phase I** at a process temperature above 450°C: formation of a layer-grid structure (type I) orientated perpendicularly to the metal film in the separation layer (4) at the transition to the metal film (3) until there is saturated formation of metastable complexes from the metal and the chalcogen under the control of the reaction gas,
• **growth phase II**: formation of a layer-grid structure (type II) orientated parallel to the semiconductor layer in the separation layer (4) at the transition to the semiconductor layer (6) by decomposition of the metastable complexes under the influence of the semiconductor material used as a catalyst and as a function of the diffusion of the metal from the metal film (3) into the separation layer (4),
• pull-off of the semiconductor layer (6) from the substrate (2) with mechanical layer separation directly at the transition to the separation layer (4), with no residues of the separation layer (4) remaining at the semiconductor layer (6),
• further processing and/or further treatment of the semiconductor layer (6) that has been pulled off.

6. Method according to claim 5 having a cyclic repetition of the run of the method with variation of the materials used.

7. Method according to claim 5 or 6 having a mask structuring of the separation layer (4).

8. Method according to one of claims 5 to 7 with coating of the substrate (2) with a metal film (3) by sputtering thereon at a process pressure in a range of 0.3 kPa to 1 kPa or vapour-deposition.

9. Method according to one of claims 5 to 8 with molybdenum for the production of the metal film (3), with binary Ga₂Se₃ and/or Cu₂Se as source materials for the deposition of the semiconductor layer (6), with copper (Cu), gallium (Ga), indium (in), nickel (Ni) or an alkali metal as a catalyst, with hydrogen (H₂) as a transport gas and hydrogen chloride (HCL) as a reaction gas.

10. Method according to claim 9 with the process parameters a process temperature as a substrate temperature in a range of 480°C to 530°C, a process pressure in a range of 5 kPa to 50 kPa, a hydrogen stream in a range of 1000 ml/min to 2000 ml/min and a hydrogen-chloride stream in a range of 50 ml/min to 500 ml/min.

## Revendications

1. Agencement de couches semi-conductrices à liaison hétérogène sur un substrat, avec au moins une couche de séparation intermédiaire qui présente une structure réticulaire prédéterminée de la couche par rapport à la séparation mécanique définie des couches semi-conductrices en associant une chalcogénure dans toutes les couches,
**caractérisé en ce que**
le substrat (2) est recouvert d'un film métallique (3) et la couche de séparation (4) est réalisée sous la forme d'une couche de dichalcogénure métallique en associant le métal du film métallique (3) et la chalcogénure d'au moins une couche semi-conductrice (6) et présente une structure continue de vases (5) courbés avec une structure réticulaire des couches (type I) à la jonction du film métallique (3) perpendiculaire à celui-ci et une structure réticulaire des couches (type II) à la jonction de la couche semi-conductrice (6) parallèle à celle-ci, la séparation mécanique pouvant être réalisée sans résidus par rapport à la couche semi-conductrice (6).

2. Agencement de couches selon la revendication 1,
**caractérisé en ce que**
le substrat (2) a la forme d'un substrat rigide en verre.

3. Agencement de couches selon la revendication 1 ou 2,
**caractérisé en ce que**
le film métallique (3) est composé de molybdène (Mo), la couche semi-conductrice (6) de diséléniure de cuivre gallium ternaire (CuGaSe₂) et la couche de séparation (4) de diséléniure de molybdène (MoSe₂).

4. Agencement de couches selon l'une des revendications 1 à 3,
**caractérisé en ce que**,
sur la couche semi-conductrice (6), dans une réalisation sous forme de couche d'absorption, une feuille de cuivre souple est appliquée comme contact arrière et, sur sa face libre obtenue après enlèvement de la couche de séparation (4) sans laisser de résidus, une couche tampon, une couche de fenêtre et des contacts frontaux métalliques sont appliqués, les contacts étant fixés au moyen d'une colle conductrice.

5. Procédé de fabrication d'un agencement de couches (1) semi-conductrices à liaison hétérogène sur un substrat (2), avec au moins une couche de séparation (4) intermédiaire qui présente une structure réticulaire prédéterminée de la couche par rapport à la séparation mécanique définie des couches semi-conductrices (6) en associant une chalcogénure dans toutes les couches, notamment selon les revendications 1 à 4, comprenant les étapes essentielles suivantes du procédé:
- recouvrement d'un substrat (2) avec un film métallique (3),
- séparation dans un système ouvert d'au moins une couche semi-conductrice (6) par séparation chimique en phase gazeuse de deux matériaux semi-conducteurs différents ou plus sur le substrat (2), au moins un des matériaux semi-conducteurs (6) provenant du groupe des chalcogénures et un autre servant de catalyseur pour former in situ en deux étapes une couche de dichalcogénure métallique servant de couche de séparation mécanique (4) entre le film métallique (3) et la couche semi-conductrice (6) en associant le métal du film métallique (3) et la chalcogénure de la couche semi-conductrice (6), en présence d'un gaz de transport et d'un gaz de réaction, comprenant les deux phases de croissance suivantes :
- **phase de croissance I** à une température de processus supérieure à 450°C : formation d'une structure réticulaire de la couche (type I) orientée perpendiculairement au film métallique dans la couche de séparation (4) à la jonction du film métallique (3) jusqu'à la formation saturée de complexes métastables du métal et de la chalcogénure sous le contrôle du gaz de réaction,
- **phase de croissance II** : formation d'une structure réticulaire de la couche (type II) orientée parallèlement à la couche semi-conductrice dans la couche de séparation (4) à la jonction de la couche semi-conductrice (6) en décomposant les complexes métastables sous l'influence du matériau semi-conducteur servant de catalyseur et en fonction de la diffusion du métal du film métallique (3) dans la couche de séparation (4),
- enlèvement de la couche semi-conductrice (6) du substrat (2) par une séparation mécanique des couches directement à la jonction de la couche de séparation (4), aucun résidu de la couche de séparation (4) ne restant au niveau de la couche semi-conductrice (6),
- re-processus et/ou retraitement de la couche semi-conductrice (6) enlevée.

6. Procédé selon la revendication 5, consistant à répéter cycliquement le déroulement du procédé en faisant varier les matériaux utilisés.

7. Procédé selon la revendication 5 ou 6, comprenant une structuration par masquage de la couche de séparation (4).

8. Procédé selon l'une des revendications 5 à 7, consistant à recouvrir le substrat (2) d'un film métallique (3) par pulvérisation à une pression de processus comprise dans une plage de 0,3 kPa à 1 kPa, ou par vaporisation.

9. Procédé selon l'une des revendications 5 à 8, comprenant du molybdène pour fabriquer le film métallique (3), du Ga₂Se₃ binaire et/ou du Cu₂Se comme matériaux sources pour séparer la couche semi-conductrice (6), du cuivre (Cu), du gallium (Ga), de l'indium (In), du nickel (Ni) ou un métal alcalin servant de catalyseur, avec de l'hydrogène (H₂) comme gaz de transport et de l'acide chlorhydrique (HCL) comme gaz de réaction.

10. Procédé selon la revendication 9, comprenant les paramètres de processus suivants : une température de processus comme température de substrat comprise dans une plage de 480°C à 530°C, une pression de processus comprise dans une plage de 5 kPa à 50 kPa, un flux d'hydrogène compris dans une plage de 1000 ml/min à 2000 ml/min et un flux d'acide chlorhydrique compris dans une plage de 50 ml/min à 500 ml/min.
